# EUROPEAN PATENT SPECIFICATION

(11) **EP 3 407 383 B1**
(45) Date of publication and mention of the grant of the patent: **18.11.2020**
(21) Application number: 17176454.1
(22) Date of filing: 16.06.2017
(51) Int. Cl.: H01L 23/525, H01L 27/112, G11C 17/16, G11C 17/18, H01L 29/78

(54) **NON-VOLATILE MEMORY AND METHOD FOR PROGRAMMING AND READING A MEMORY ARRAY HAVING THE SAME**
NICHTFLÜCHTIGER SPEICHER UND VERFAHREN ZUR PROGRAMMIERUNG UND ZUM LESEN EINER SPEICHERMATRIX DAMIT
MÉMOIRE NON VOLATILE ET PROCÉDÉ DE PROGRAMMATION ET DE LECTURE D'UN RÉSEAU DE MÉMOIRE LA COMPRENANT

(30) Priority: 25.05.2017 US 201715604672
(43) Date of publication of application: 28.11.2018
(73) Proprietor: eMemory Technology Inc., Hsinchu 300 (TW)
(72) Inventor: Wu, Meng-Yi, 302 Hsinchu County (TW); Chen, Hsin-Ming, 300 Hsinchu City (TW)
(74) Representative: Straus, Alexander

(56) References cited:
- US-A1- 2010 232 203
- US-A1- 2016 141 295
- US-A1- 2017 076 757
- US-A1- 2017 117 058
- US-B1- 9 536 991
- US-B1- 9 589 970

## Description

### Field of the Invention

The present invention relates to a non-volatile memory (NVM), and more particularly, to a non-volatile memory having one-time programmable (OTP) memory cells.

### Background of the Invention

As is well known, a non-volatile memory is able to continuously retain data after the supplied power is interrupted. Generally, after the non-volatile memory leaves the factory, the user may program the non-volatile memory in order to record data into the non-volatile memory.

According to the programming times limit, the non-volatile memories may be classified into a multi-time programmable (MTP) memory, a one-time programmable (OTP) memory and a mask read only memory (Mask ROM). Generally, the MTP memory may be programmed many times, and the stored data of the MTP memory may be modified many times. On the contrary, the OTP memory may be programmed once. After the OTP memory is programmed, the stored data fails to be modified. Moreover, after the Mask ROM leaves the factory, all stored data has been recorded therein. The user is only able to read the stored data from the Mask ROM, but is unable to program the Mask ROM.

Moreover, depending on the characteristics, the OTP memories may be classified into two types, i.e. a fuse-type OTP memory and an antifuse-type OTP memory. Before a memory cell of the fuse-type OTP memory is programmed, the memory cell has a low-resistance storing state. After the memory cell of the fuse-type OTP memory is programmed, the memory cell has a high-resistance storing state. On the other hand, the memory cell of the antifuse-type OTP memory has the high-resistance storing state before being programmed, and the memory cell of the antifuse-type OTP memory has the low-resistance storing state after being programmed.

Generally, an OTP memory may comprise a plurality of OTP memory cells, and a shallow trench isolation (STI) structure may be used to isolate two adjacent OTP memory cells. However, the OTP memory may have too many STI structures that occupy the layout area of the OTP memory. Accordingly, the effective layout area for the OTP memory cells may be shrunk.

Document US9589970 and document US2016/0141295 disclose an antifuse one-time programmable memory cell comprising fin structures;

Document US2017/0117058 discloses a non-volatile memory cell having multiple signal pathways to provide access to an antifuse of the memory cell.

Document US2017/0076757 discloses a one-time programmable memory array having a small ship area. The memory cell includes a first select transistor, a first following gate transistor, an antifuse transistor, a second following gate transistor, and a second select transistor.

Document US9,570,442 discloses a self-aligned single diffusion break (SDB) isolation structure for applying channel stress to FinFETs

### Summary of the Invention

This in mind, the present invention aims at providing a non-volatile memory and a method for programming and reading a memory array having the same.

This is achieved by a non-volatile memory and a related programming method according to claims 1 and 13. The dependent claims pertain to corresponding further developments and improvements.

As will be seen more clearly from the detailed description following below, the claimed non-volatile memory (NVM) is disclosed. The NVM comprises a fin structure, a first fin field effect transistor (FinFET), a second FinFET, an antifuse structure, a third FinFET, and a fourth FinFET. The first FinFET is formed on the fin structure and has a first gate, a first source region, and a first drain region. The second FinFET is formed on the fin structure and has a second gate, a second drain region, and a second source region coupled to the first drain region. The antifuse structure is formed on the fin structure and has a sharing gate, a single diffusion break (SDB) isolation structure, a first source/drain region, and a second source/drain region. The SDB isolation structure is formed between the first source/drain region and the second source/drain region. A top surface of the SDB isolation structure is covered by the sharing gate. The first source/drain region is coupled to the second drain region. The third FinFET is formed on the fin structure and has a third gate, a third source region, and a third drain region coupled to the second source/drain region. The fourth FinFET is formed on the fin structure and has a fourth gate, a fourth source region, and a fourth drain region coupled to the third source region.

It is an advantage that the present invention provides a non-volatile memory having an antifuse structure which forms a first antifuse element of a first OTP memory cell and a second antifuse element of a second OTP memory cell. The two OTP memory cells share the antifuse structure. Therefore, a shallow trench isolation (STI) structure between the two OTP memory cells could be omitted. As a result, the effective layout area for the OTP memory cells may be increased.

### Brief Description of the Drawings

In the following, the invention is further illustrated by way of example, taking reference to the accompanying drawings. Thereof
FIG. 1 is a diagram showing an equivalent circuit of a non-volatile memory according to a first embodiment of the present invention;
FIG. 2 is a diagram showing a layout of gates, a sharing gate and a fin structure of the non-volatile memory shown in FIG. 1;
FIG. 3 is a three-dimensional diagram showing a structure of the non-volatile memory shown in FIG. 1;
FIG. 4 is a component cross-sectional view of the non-volatile memory shown in FIG. 1;
FIG. 5 is a component cross-sectional view of the sharing gate GA and a single diffusion break (SDB) isolation structure of the non-volatile memory shown in FIG. 1;
FIG. 6 is a diagram showing a method for programming a memory array comprising the OTP memory cells of the present invention; and
FIG. 7 is a diagram showing a table listing related voltages for programming the memory array shown in FIG. 6.

### Detailed Description

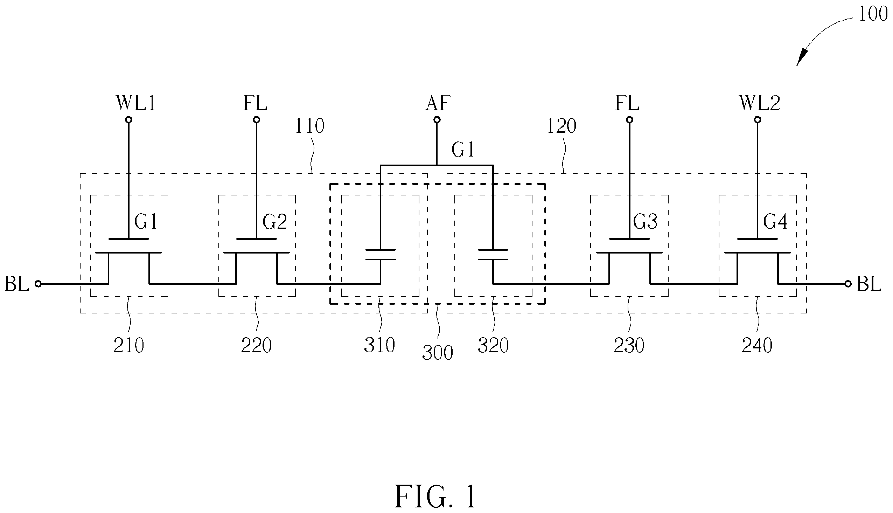

FIG. 1 is a diagram showing an equivalent circuit of a non-volatile memory (NVM) 100 according to a first embodiment of the present invention. The NVM 100 comprises a first fin field effect transistor (FinFET) 210, a second FinFET 220, an antifuse structure 300, a third FinFET 230, and a fourth FinFET 240. A first gate G1 of the first FinFET 210 is coupled to a first word line WL1, a second gate G2 of the second FinFET 220 and a third gate G3 of the third FinFET 230 are coupled to a following line FL, a fourth gate G4 of the fourth FinFET 240 is coupled to a second word line WL2, and a sharing gate GA of the antifuse structure 300 is coupled to an antifuse line AF. The first FinFET 210 and the fourth FinFET 240 are coupled to a bit line BL. The antifuse structure 300 may form a first antifuse element 310 of a first one-time programmable (OTP) memory cell 110 and a second antifuse element 320 of a second OTP memory cell 120. In the embodiment, the first OTP memory cell 110 comprises the first FinFET 210, the second FinFET 220 and the first antifuse element 310, and the second OTP memory cell 120 comprises the third FinFET 230, the fourth FinFET 240 and the second antifuse element 320. It could be noted that each of the antifuse elements 310 and 320 may be a varactor, a capacitor or a half transistor.

When programming the first OTP memory cell 110, the first antifuse element 310 would be ruptured and behave as a resistor, such that data of logic "0" would be written into the first OTP memory cell 110. Similarly, when programming the second OTP memory cell 120, the second antifuse element 320 would be ruptured and behave as a resistor, such that data of logic "0" would be written into the second OTP memory cell 120.

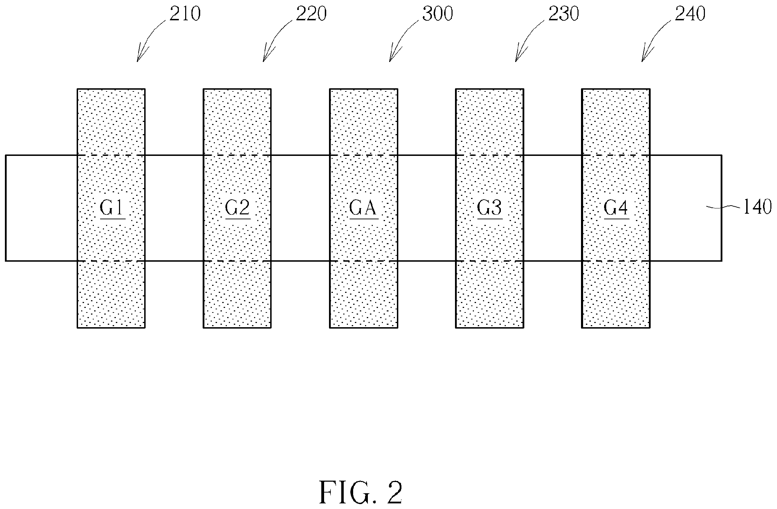

FIG. 2 is a diagram showing a layout of the gates G1 to G4, the sharing gate GA and a fin structure 140 of the non-volatile memory 100 shown in FIG. 1. The gates G1 to G4 and the sharing gate GA are formed on the fin structure 140.

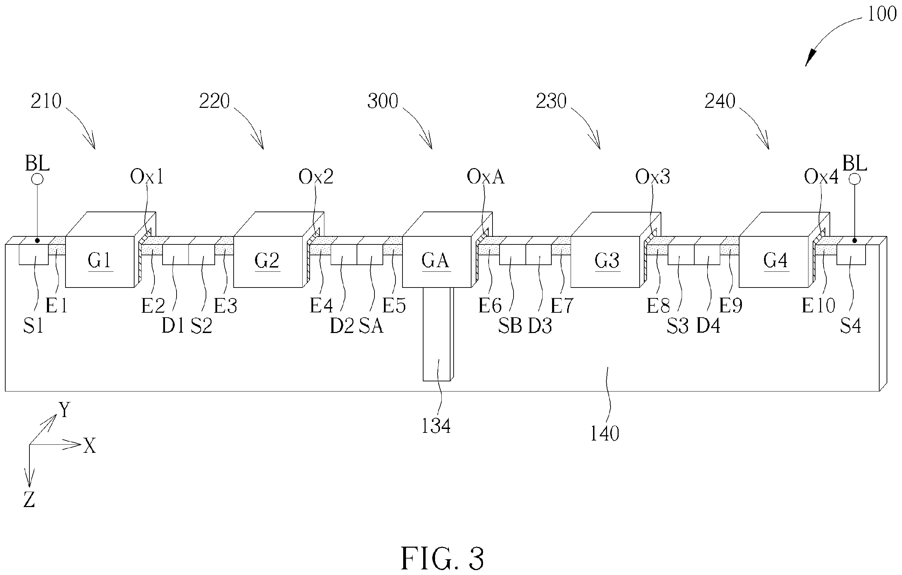

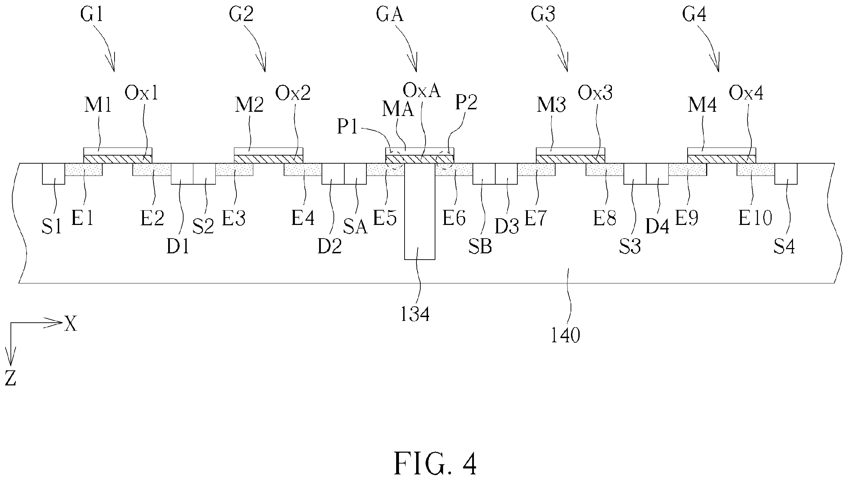

FIG. 3 is a three-dimensional diagram showing a structure of the non-volatile memory 100 shown in FIG. 1. FIG. 4 is a component cross-sectional view of the non-volatile memory 100 shown in FIG. 1. FIGs. 3 and 4 are illustrated by using Cartesian coordinate system that has three axes X, Y and Z. The first FinFET 210, the second FinFET 220, the antifuse structure 300, the third FinFET 230 and the fourth FinFET 240 are formed on the fin structure 140. The first FinFET 210 further has a first source region S1 and a first drain region D1. The first source region S1 is coupled to the bit line BL. The second FinFET further has a second drain region D2, and a second source region S2 coupled to the first drain region D1. The antifuse structure 300 further has a single diffusion break (SDB) isolation structure 134, a first source/drain region SA coupled to the second drain region D2, and a second source/drain region SB. The SDB isolation structure 134 is formed between the first source/drain region SA and the second source/drain region SB to isolate the first source/drain region SA and the second source/drain region SB. The SDB isolation structure 134 may be formed of silicon oxide. The third FinFET 230 further has a third source region S3, and a third drain region D3 coupled to the second source/drain region SB. The fourth FinFET 240 further has a fourth source region S4 coupled to the bit line BL, and a fourth drain region D4 coupled to the third source region S3. The fin structure 140 may be a P well over a silicon substrate, and the source regions S1 to S4, the drain regions D1 to D4 and the source/drain regions SA and SB may be elevated and formed on the fin structure 140 by an epitaxial silicon phosphorous (SiP) or silicon carbide (SiC) process.

In addition, the first gate G1 has a metal layer M1 and a gate oxide layer Ox1 formed between the metal layer M1 and the fin structure 140. The second gate G2 has a metal layer M2 and a gate oxide layer Ox2 formed between the metal layer M2 and the fin structure 140. The sharing gate GA may be a poly over diffusion edge (PODE) formed by performing FinFET processes (i.e. the processes of manufacturing the non-volatile memory 100) and may be used as a gate of an antifuse. The sharing gate GA has a metal layer MA and a gate oxide layer OxA formed between the metal layer MA and the fin structure 140. The third gate G3 has a metal layer M3 and a gate oxide layer Ox3 formed between the metal layer M3 and the fin structure 140. The fourth gate G4 has a metal layer M4 and a gate oxide layer Ox4 formed between the metal layer M4 and the fin structure 140. The thicknesses of the metal layers M1, M2, M3, M4 and MA may be the same, and thicknesses of the gate oxide layers Ox1, Ox2, Ox3, Ox4 and OxA may be the same.

When the OTP memory cell 110 is programmed, a portion PI of the gate oxide layer OxA is ruptured (i.e., the first antifuse element 310 is ruptured). When the OTP memory cell 120 is programmed, a portion P2 of the gate oxide layer OxA is ruptured (i.e., the second antifuse element 320 is ruptured).

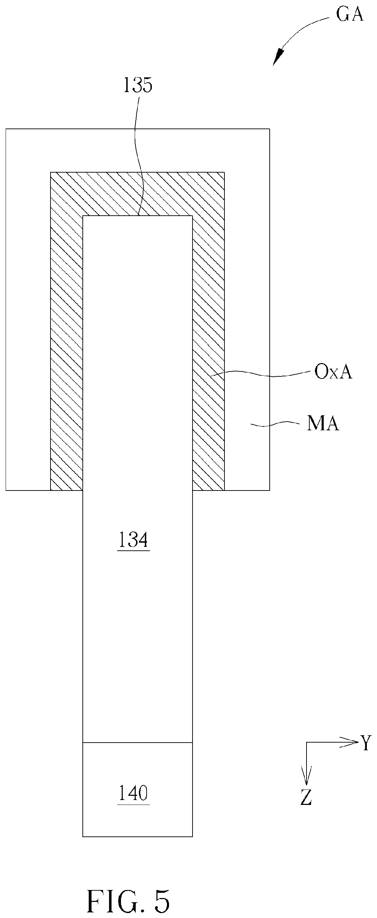

FIG. 5 is a component cross-sectional view of the sharing gate GA and a single diffusion break (SDB) isolation structure 134 of the non-volatile memory 100 shown in FIG. 1. The sharing gate GA has a U shape to overlap three lateral sides of the SDB isolation structure 134. Therefore, a top surface 135 of the SDB isolation structure 134 is covered by the sharing gate GA. Similarly, each of the first gate G1, the second gate G2, the third gate G3 and the fourth gate G4 has a U shape to overlap three lateral sides of the fin structure 140.

In another embodiment of the present invention, the first FinFET 210 may further have a first source/drain extension area E1 and a second source/drain extension area E2. The first source/drain extension area E1 is coupled to the first source region S1 and partially covered by the first gate G1. The second source/drain extension area E2 is coupled to the first drain region D1 and partially covered by the first gate G1. The second FinFET 220 may further have a third source/drain extension area E3 and a fourth source/drain extension area E4. The third source/drain extension area E3 is coupled to the second source region S2 and partially covered by the second gate G2. The fourth source/drain extension area E4 is coupled to the second drain region D2 and partially covered by the second gate G2. The antifuse structure 300 may further have a fifth source/drain extension area E5 and a sixth source/drain extension area E6. The fifth source/drain extension area E5 is coupled to the first source/drain region SA and partially covered by the sharing gate GA. The sixth source/drain extension area E6 is coupled to the second source/drain region SB and partially covered by the sharing gate GA. The third FinFET 230 may further have a seventh source/drain extension area E7 and an eighth source/drain extension area E8. The seventh source/drain extension area E7 is coupled to the third drain region D3 and partially covered by the third gate G3. The eighth source/drain extension area E8 is coupled to the third source region S3 and partially covered by the third gate G3. The fourth FinFET 240 may further have a ninth source/drain extension area E9 and a tenth source/drain extension area E10. The ninth source/drain extension area E9 is coupled to the fourth drain region D4 and partially covered by the fourth gate G4. The tenth source/drain extension area E10 is coupled to the fourth source region S4 and partially covered by the fourth gate G4. In another embodiment of the present invention, the third source/drain extension area E3, the fourth source/drain extension area E4, the seventh source/drain extension area E7 and the eighth source/drain extension area E8 could be omitted.

According to the above arrangement, since the antifuse structure 300 forms the first antifuse element 310 of the first OTP memory cell 110 and the second antifuse element 320 of the second OTP memory cell 120, the two OTP memory cells 110 and 120 share the antifuse structure 300. Therefore, a shallow trench isolation (STI) structure between the two OTP memory cells 110 and 120 could be omitted. As a result, the effective layout area for the OTP memory cells may be increased.

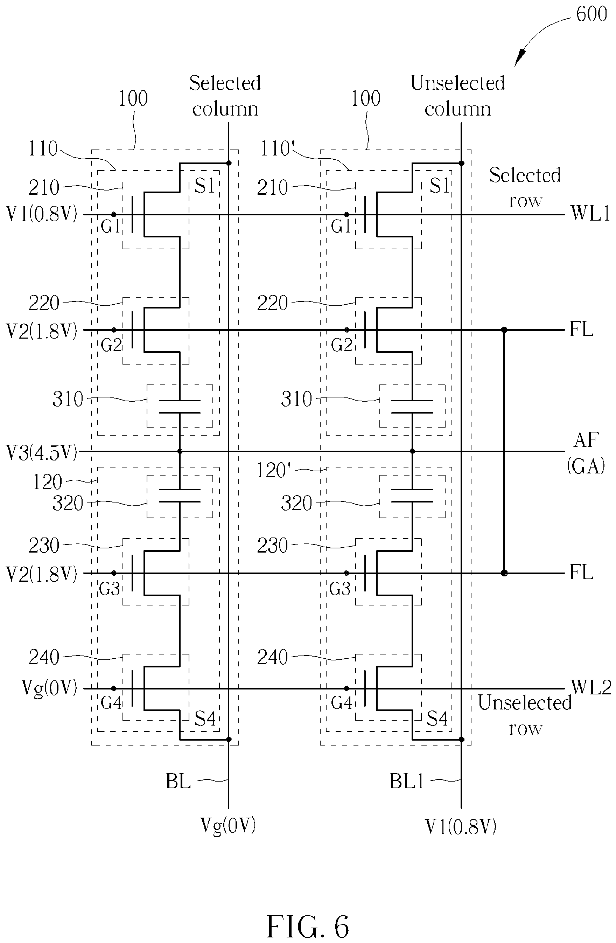

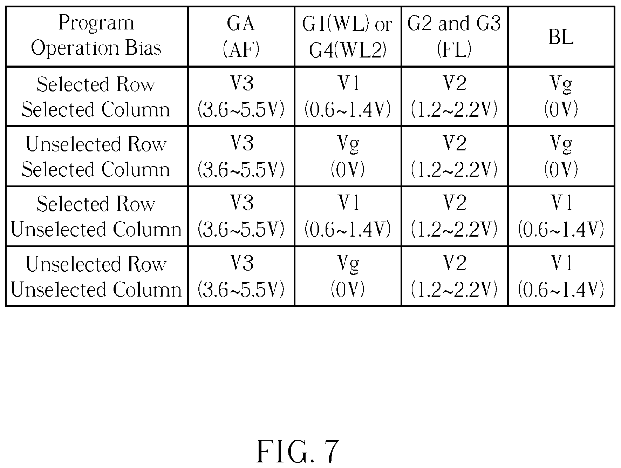

FIG. 6 is a diagram showing a method for programming a memory array 600 comprising the OTP memory cells of the present invention. FIG. 7 is a diagram showing a table listing related voltages for programming the memory array shown in FIG. 6. For the sake of simplicity, only two non-volatile memories (NVMs) 100 are illustrated in FIG. 6. However, the memory array 600 may comprise a plurality of NVMs 100 arranged in a matrix having a plurality of rows and a plurality of columns, and each OTP memory cell of the NVMs 100 is located at a corresponding row and a corresponding column. Each of the NVMs 100 has two OTP memory cells. For example, as shown in FIG. 6, the left NVM 100 has two OTP memory cells 110 and 120, and the right NVM 100 has two OTP memory cells 110' and 120'. In the embodiment, it is assumed that the upper left OTP memory cell 110 is selected to be programmed. When programming the selected OTP memory cell 110, a first voltage V1 (such as 0.8V) is provided to the first gates G1 at a selected row via the first word line WL1, a second voltage V2 (such as 1.8V) is provided to all second gates G2 and all third gates G3 of the memory array 600 via the following line FL, a third voltage V3 (such as 4.5V) is provided to all sharing gates GA of the memory array 600 via the antifuse line AF. Besides, a ground voltage Vg (such as 0V) is provided to the first source region S1 and the fourth source region S4 of the NVM 100 at a selected column via the bit line BL. The third voltage V3 is greater than the first voltage VI and the second voltage V2, and the first voltage V1 and the second voltage V2 are greater than the ground voltage Vg. The first voltage V1 may range from 0.6 volts to 1.4 volts, the second voltage V2 may range from 1.2 volts to 2.2 volts, and the third voltage V3 may range from 3.6 volts to 5.5 volts.

According to the above programming operations, the first antifuse element 310 of the selected OTP memory cell 110 can be ruptured to be a resistor by the third voltage V3, such that data of logic "0" is written into the selected OTP memory cell 110 at the selected row and the selected column. On the other hand, for writing data of logic "1" into the selected OTP memory cell 110 at the selected row and column, the voltage level at the sharing gate GA can be set at 0V.

In addition, for unselected OTP memory cells 120 and 120' at an unselected row, the ground voltage Vg is provided to the fourth gates G4 of the unselected OTP memory cells 120 and 120'. For the unselected OTP memory cells 110' and 120' at an unselected column, the first voltage V1 is provided to the first source region S1 of the unselected OTP memory cell 110' and the fourth source region S4 of the unselected OTP memory cell 120' via the bit line BL1. Therefore, the unselected OTP memory cells 110', 120 and 120' can be set in a program inhibition status.

When reading data of the selected memory cell 100, the bit line BL is at the ground voltage Vg, a device voltage VDD is provided to the first gate G1 and the second gate G2 via the word line WL1 and the following line FL, and the second voltage V2 or the device voltage VDD is provided to the sharing gate GA via the antifuse line AF. Moreover, if any OTP memory cell 110, 100', 120 or 120' in a read inhibition status, a corresponding word line WL1 or WL2 coupled to the memory cell may be applied by the ground voltage Vg.

In the previous embodiments, the first gate G1 of the first FinFET 210 and the fourth gate G4 of the fourth FinFET 240 are coupled to two different word lines WL1 and WL2. In another embodiment of the present invention, the first gate G1 of the first FinFET 210 and the fourth gate G4 of the fourth FinFET 240 may be coupled to a same word line, and the two OTP memory cells of each NVM 100 only record a single bit after the NVM 100 is programmed. For example, both of the first gate G1 and the fourth gate G4 of a single NVM 100 may be coupled to the word line WL1, and the two OTP memory cells of the single NVM 100 would store one bit after the single NVM 100 is programmed.

## Claims

1. A non-volatile memory (100) comprising:
a fin structure (140);
a first fin field effect transistor (210), formed on the fin structure (140) and having a first gate (G1), a first source region (S1), and a first drain region (D1);
a second fin field effect transistor (220), formed on the fin structure (140) and having a second gate (G2), a second drain region (D2), and a second source region (S2) coupled to the first drain region (D1);
an antifuse structure (300), formed on the fin structure (140) and having a sharing gate (GA), a single diffusion break isolation structure (134), a first source/drain region (SA), and a second source/drain region (SB), wherein the single diffusion break isolation structure (134) is formed on the fin structure (140) and formed between the first source/drain region (SA) and the second source/drain region (SB), a top surface (135) of the single diffusion break isolation structure (134) is covered by the sharing gate (GA), and the first source/drain region (SA) is coupled to the second drain region (D2);
a third fin field effect transistor (230), formed on the fin structure (140) and having a third gate (G3), a third source region (S3), and a third drain region (D3) coupled to the second source/drain region (SB); and
a fourth fin field effect transistor (240), formed on the fin structure (140) and having a fourth gate (G4), a fourth source region (S4), and a fourth drain region (D4) coupled to the third source region (S3).

2. The non-volatile memory (100) of claim 1, wherein the antifuse structure (300) forms a first antifuse element (310) and a second antifuse element (320).

3. The non-volatile memory (100) of claim 2, wherein the first fin field effect transistor (210), the second fin field effect transistor (220) and the first antifuse element (310) compose a first one-time programmable memory cell (110), and the third fin field effect transistor (230), the fourth fin field effect transistor (240) and the second antifuse element (320) compose a second one-time programmable memory cell (120).

4. The non-volatile memory (100) of any of claims 1 to 3, wherein the single diffusion break isolation structure (134) isolates the first source/drain region (SA) and the second source/drain region (SB).

5. The non-volatile memory (100) of any of claims 1 to 4, wherein the first fin field effect transistor (210) further comprises:
a first source/drain extension area (E1), coupled to the first source region (S1) and partially covered by the first gate (G1); and
a second source/drain extension area (E2), coupled to the first drain region (D1) and partially covered by the first gate (G1);
the antifuse structure (300) further comprises:
a fifth source/drain extension area (E5), coupled to the first source/drain region (SA) and partially covered by the sharing gate (GA); and
a sixth source/drain extension area (E6), coupled to the second source/drain region (SB) and partially covered by the sharing gate (GA); and
the fourth fin field effect transistor (240) further comprises:
a ninth source/drain extension area (E9), coupled to the fourth drain region (D4) and partially covered by the fourth gate (G4); and
a tenth source/drain extension area (E10), coupled to the fourth source region (S4) and partially covered by the fourth gate (G4).

6. The non-volatile memory (100) of claim 5, wherein the second fin field effect transistor (220) further comprises:
a third source/drain extension area (E3), coupled to the second source region (S2) and partially covered by the second gate (G2); and
a fourth source/drain extension area (E4), coupled to the second drain region (D2) and partially covered by the second gate (G2); and
wherein the third fin field effect transistor (230) further comprises:
a seventh source/drain extension area (E7), coupled to the third drain region (D3) and partially covered by the third gate (G3); and
an eighth source/drain extension area (E8), coupled to the third source region (S3) and partially covered by the third gate (G3).

7. The non-volatile memory (100) of any of claims 1 to 6, wherein the second gate (G2) is coupled to the third gate (G3).

8. The non-volatile memory (100) of any of claims 1 to 7, wherein the first source region (S1) is coupled to the fourth source region (S4).

9. The non-volatile memory (100) of any of claims 1 to 8, wherein the first gate (G1) is coupled to the fourth gate (G4).

10. The non-volatile memory (100) of any of claims 1 to 9, wherein the fin structure (140) is a P well over a silicon substrate, and all source regions (S1, S2, S3 and S4), all drain regions (D1, D2, D3 and D4) and all source/drain regions (SA and SB) are formed by an epitaxial silicon phosphorous or silicon carbide process.

11. The non-volatile memory (100) of any of claims 1 to 10, wherein each of the first gate (G1), the second gate (G2), the third gate (G3) and the fourth gate (G4) has a U shape to overlap three lateral sides of the fin structure (140).

12. The non-volatile memory (100) of any of claims 1 to 11, wherein the sharing gate (GA) has a U shape to overlap three lateral sides of the single diffusion break isolation structure (134).

13. A method for programming a memory array (600) comprising:
providing a memory array (600) comprising a plurality of the non-volatile memories (100) each being the non-volatile memory (100) of claim 1;
providing a first voltage (V1) ranging from 0.6 volts to 1.4 volts to first gates (G1) or fourth gates (G4) of non-volatile memories (100) at a selected row (WL1) of the memory array (600);
providing a second voltage (V2) ranging from 1.2 volts to 2.2 volts to second gates (G2) and third gates (G3) of the plurality of non-volatile memories (100) of the memory array (600);
providing a third voltage (V3) ranging from 3.6 volts to 5.5 volts to sharing gates (GA) of the plurality of non-volatile memories (100) of the memory array (600); and
providing a ground voltage (Vg) to first source regions (S1) of non-volatile memories (100) at a selected column (BL) of the memory array (600);
wherein the third voltage (V3) is greater than the first voltage (V1) and the second voltage (V2), and the first voltage (V1) and second voltage (V2) are greater than the ground voltage (V3).

14. The method of claim 13, further comprising:
providing the first voltage (V1) to first source regions (S1) of non-volatile memories (100) at unselected columns (BL1) of the memory array (600).

15. The method of any of claims 13 to 14, further comprising:
providing the ground voltage (Vg) to first gates (G1) and fourth gates (G4) of non-volatile memories (100) at unselected rows (WL2) of the memory array (600).

## Patentansprüche

1. Nicht flüchtiger Speicher (100), welcher umfasst:
einen Grat-Aufbau (140);
einen ersten Grat-Feldeffekttransistor (210), der auf dem Grat-Aufbau (140) ausgebildet ist und ein erstes Gate (G1), einen ersten Quellenbereich (S1), und einen ersten Abfließbereich (D1) aufweist;
einen zweiten Grat-Feldeffekttransistor (220), der auf dem Grat-Aufbau (140) ausgebildet ist und ein zweites Gate (G2), einen zweiten Abfließbereich (D2), und einen zweiten Quellenbereich (S2) aufweist, der mit dem ersten Abfließbereich (D1) gekoppelt ist;
einen Antisicherungs-Aufbau (300), der auf dem Grat-Aufbau (140) ausgebildet ist und ein Sharing-Gate (GA), einen Einzel-Diffusionssperren-Isolationsaufbau (134), einen ersten Quellen-/Abfließbereich (SA), und einen zweiten Quellen-/Abfließbereich (SB) aufweist, worin der Einzel-Diffusionssperren-Isolationsaufbau (134) auf dem Grat-Aufbau (140) und zwischen dem ersten Quellen-/Abfließbereich (SA) und dem zweiten Quellen-/Abfließbereich (SB) ausgebildet wird, worin eine obere Oberfläche (135) des Einzel-Diffusionssperren-Isolationsaufbaus (134) durch das Sharing-Gate (GA) bedeckt ist, und worin der erste Quellen-/Abfließbereich (SA) mit dem zweiten Abfließbereich (D2) gekoppelt ist;
einen dritten Grat-Feldeffekttransistor (230), der auf dem Grat-Aufbau (140) ausgebildet ist und ein drittes Gate (G3), einen dritten Quellenbereich (S3), und einen dritten Abfließbereich (D3) aufweist, der mit dem zweiten Quellen-/Abfließbereich (SB) gekoppelt ist; und
einen vierten Grat-Feldeffekttransistor (240), der auf dem Grat-Aufbau (140) ausgebildet ist und ein viertes Gate (G4), einen vierten Quellenbereich (S4), und einen vierten Abfließbereich (D4) aufweist, der mit dem dritten Quellenbereich (S3) gekoppelt ist.

2. Nicht flüchtiger Speicher (100) nach Anspruch 1, worin der Antisicherungs-Aufbau (300) ein erstes Antisicherungs-Element (310) und ein zweites Antisicherungs-Element (320) ausbildet.

3. Nicht flüchtiger Speicher (100) nach Anspruch 2, worin der erste Grat-Feldeffekttransistor (210), der zweite Grat-Feldeffekttransistor (220) und das erste Antisicherungs-Element (310) eine erste Einmal-Programmierbare-Speicherzelle (110) ausbilden, und worin der dritte Grat-Feldeffekttransistor (230), der vierte Grat-Feldeffekttransistor (240) und das zweite Antisicherungs-Element (320) eine zweite Einmal-Programmierbare-Speicherzelle (120) ausbilden.

4. Nicht flüchtiger Speicher (100) nach einem der Ansprüche 1 bis 3, worin der Einzel-Diffusionssperren-Isolationsaufbau (134) den ersten Quellen-/Abfließbereich (SA) und den zweiten Quellen-/Abfließbereich (SB) isoliert.

5. Nicht flüchtiger Speicher (100) nach einem der Ansprüche 1 bis 4, worin der erste Grat-Feldeffekttransistor (210) weiter umfasst:
eine erste Quellen-/Abfließ-Erstreckungsfläche (E1), die mit dem ersten Quellenbereich (S1) gekoppelt und teilweise durch das erste Gate (G1) bedeckt ist; und
eine zweite Quellen-/Abfließ-Erstreckungsfläche (E2), die mit dem ersten Abfließbereich (D1) gekoppelt und teilweise durch das erste Gate (G1) bedeckt ist;
worin der Antisicherungs-Aufbau (300) weiter umfasst:
eine fünfte Quellen-/Abfließ-Erstreckungsfläche (E5), die mit dem ersten Quellen-/Abfließbereich (SA) gekoppelt und teilweise durch das Sharing-Gate (GA) bedeckt ist; und
eine sechste Quellen-/Abfließ-Erstreckungsfläche (E6), die mit dem zweiten Quellen-/Abfließbereich (SB) gekoppelt und teilweise durch das Sharing-Gate (GA) bedeckt ist; und
worin der vierte Grat-Feldeffekttransistor (240) weiter umfasst:
einen neunte Quellen-/Abfließ-Erstreckungsfläche (E9), die mit dem vierten Abfließbereich (D4) gekoppelt und teilweise durch das vierte Gate (G4) bedeckt ist; und
eine zehnte Quellen-/Abfließ-Erstreckungsfläche (E10), die mit dem vierten Quellenbereich (S4) gekoppelt und teilweise durch das vierte Gate (G4) bedeckt ist.

6. Nicht flüchtiger Speicher (100) nach Anspruch 5, worin der zweite Grat-Feldeffekttransistor (220) weiter umfasst:
eine dritte Quellen-/Abfließ-Erstreckungsfläche (E3), die mit dem zweiten Quellenbereich (S2) gekoppelt und teilweise durch das zweite Gate (G2) bedeckt ist; und
eine vierte Quellen-/Abfließ-Erstreckungsfläche (E4), die mit dem zweiten Abfließbereich (D2) gekoppelt und teilweise durch das zweite Gate (G2) bedeckt ist; und
worin der dritte Grat-Feldeffekttransistor (230) weiter umfasst:
eine siebte Quellen-/Abfließ-Erstreckungsfläche (E7), die mit dem dritten Abfließbereich (D3) gekoppelt und teilweise durch das dritte Gate (G3) bedeckt ist; und
eine achte Quellen-/Abfließ-Erstreckungsfläche (E8), die mit dem dritten Quellenbereich (S3) gekoppelt und teilweise durch das dritte Gate (G3) bedeckt ist.

7. Nicht flüchtiger Speicher (100) nach einem der Ansprüche 1 bis 6, worin das zweite Gate (G2) mit dem dritten Gate (G3) gekoppelt ist.

8. Nicht flüchtiger Speicher (100) nach einem der Ansprüche 1 bis 7, worin der erste Quellenbereich (S1) mit dem vierten Quellenbereich (S4) gekoppelt ist.

9. Nicht flüchtiger Speicher (100) nach einem der Ansprüche 1 bis 8, worin das erste Gate (G1) mit dem vierten Gate (G4) gekoppelt ist.

10. Nicht flüchtiger Speicher (100) nach einem der Ansprüche 1 bis 9, worin der Grat-Aufbau (140) eine P-Wanne über einem Siliziumsubstrat ist, und alle Quellenbereiche (S1, S2, S3 und S4), alle Abfließbereiche (D1, D2, D3 und D4) und alle Quellen-/Abfließbereiche (SA und SB) durch einen epitaktisches Siliziumphosphor- oder Siliziumcarbid-Verfahren ausgebildet werden.

11. Nicht flüchtiger Speicher (100) nach einem der Ansprüche 1 bis 10, worin jedes von dem ersten Gate (G1), dem zweiten Gate (G2), dem dritten Gate (G3) und dem vierten Gate (G4) eine U-Form aufweisen, um an drei lateralen Seiten des Grat-Aufbaus (140) zu überlappen.

12. Nicht flüchtiger Speicher (100) nach einem der Ansprüche 1 bis 11, worin das Sharing-Gate (GA) eine U-Form aufweist, um mit drei lateralen Seiten des Einzel-Diffusionssperren-Isolationsaufbaus (134) zu überlappen.

13. Verfahren zum Programmieren einer Speicheranordnung (600), welches umfasst:
Bereitstellen einer Speicheranordnung (600), die mehrere der nicht flüchtigen Speicher (100) umfasst, die jeweils die nicht flüchtigen Speicher (100) nach Anspruch 1 sind;
Anlegen einer ersten Spannung (V1) im Bereich von 0,6 Volt bis 1,4 Volt an erste Gates (G1) oder vierte Gates (G4) der nicht flüchtigen Speicher (100) an einer ausgewählten Reihe (WL1) der Speicheranordnung (600);
Anlegen einer zweiten Spannung (V2) im Bereich von 1,2 Volt bis 2,2 Volt an zweite Gates (G2) und dritte Gates (G3) der mehreren nicht flüchtigen Speicher (100) der Speicheranordnung (600);
Anlegen einer dritten Spannung (V3) im Bereich von 3,6 Volt bis 5,5 Volt an Sharing-Gates (GA) der mehreren nicht flüchtigen Speicher (100) der Speicheranordnung (600); und
Anlegen einer Erde-Spannung (Vg) an erste Quellenbereiche (S1) der nicht flüchtigen Speicher (100) an einer ausgewählten Säule (BL) der Speicheranordnung (600);
wobei die dritte Spannung (V3) größer ist als die erste Spannung (V1) und die zweite Spannung (V2), und wobei die erste Spannung (V1) und zweite Spannung (V2) größer sind als die Erde-Spannung (V3).

14. Verfahren nach Anspruch 13, welches weiter umfasst:
Anlegen der ersten Spannung (V1) an erste Quellenbereiche (S1) der nicht flüchtigen Speicher (100) an nicht ausgewählten Säulen (BL1) der Speicheranordnung (600).

15. Verfahren nach einem der Ansprüche 13 bis 14, welches weiter umfasst:
Anlegen der Erde-Spannung (Vg) an erste Gates (G1) und vierte Gates (G4) der nichtflüchtigen Speicher (100) an nicht ausgewählten Reihen (WL2) der Speicheranordnung (600).

## Revendications

1. Mémoire non volatile (100) comprenant :
une structure à ailettes (140) ;
un premier transistor à effet de champ à ailette (210), formé sur la structure à ailettes (140) et présentant une première grille (G1), une première région de source (S1) et une première région de drain (D1) ;
un deuxième transistor à effet de champ à ailette (220), formé sur la structure à ailettes (140) et présentant une deuxième grille (G2), une deuxième région de drain (D2) et une deuxième région de source (S2) couplée à la première région de drain (D1) ;
une structure antifusible (300) formée sur la structure à ailettes (140) et présentant une grille de partage (GA), une structure d'isolation à rupture de diffusion unique (134), une première région de source/drain (SA) et une deuxième région de source/drain (SB), la structure d'isolation à rupture de diffusion unique (134) étant formée sur la structure à ailettes (140) et formée entre la première région de source/drain (SA) et la deuxième région de source/drain (SB), une surface supérieure (135) de la structure d'isolation à rupture de diffusion unique (134) étant recouverte par la grille de partage (GA) et la première région de source/drain (SA) étant couplée à la deuxième région de drain (D2) ;
un troisième transistor à effet de champ à ailette (230), formé sur la structure à ailettes (140) et présentant une troisième grille (G3), une troisième région de source (S3) et une troisième région de drain (D3) couplée à la deuxième région de source/drain (SB) ; et
un quatrième transistor à effet de champ à ailette (240), formé sur la structure à ailettes (140) et présentant une quatrième grille (G4), une quatrième région de source (S4) et une quatrième région de drain (D4) couplée à la troisième région de source (53).

2. Mémoire non volatile (100) selon la revendication 1, la structure antifusible (300) formant un premier élément antifusible (310) et un deuxième élément antifusible (320).

3. Mémoire non volatile (100) selon la revendication 2, le premier transistor à effet de champ à ailette (210), le deuxième transistor à effet de champ à ailette (220) et le premier élément antifusible (310) composant une première cellule de mémoire (110) programmable une seule fois et le troisième transistor à effet de champ à ailette (230), le quatrième transistor à effet de champ à ailette (240) et le deuxième élément antifusible (320) composant une deuxième cellule de mémoire (120) programmable une seule fois.

4. Mémoire non volatile (100) selon l'une quelconque des revendications 1 à 3, la structure d'isolation à rupture de diffusion unique (134) isolant la première région de source/drain (SA) et la deuxième région de source/drain (SB).

5. Mémoire non volatile (100) selon l'une quelconque des revendications 1 à 4, le premier transistor à effet de champ à ailette (210) comprenant en outre :
une première zone d'extension de source/drain (E1), couplée à la première région de source (S1) et partiellement couverte par la première grille (G1) ; et
une deuxième zone d'extension de source/drain (E2), couplée à la première région de drain (D1) et partiellement couverte par la première grille (G1) ;
la structure antifusible (300) comprenant en outre :
une cinquième zone d'extension de source/drain (E5), couplée à la première région de source/drain (SA) et partiellement couverte par la grille de partage (GA) ; et
une sixième zone d'extension de source/drain (E6), couplée à la deuxième région de source/drain (SB) et partiellement couverte par la grille de partage (GA) ; et
le quatrième transistor à effet de champ à ailette (240) comprenant en outre :
une neuvième zone d'extension de source/drain (E9), couplée à la quatrième région de drain (D4) et partiellement couverte par la quatrième grille (G4) ; et
une dixième zone d'extension de source/drain (E10), couplée à la quatrième région de source (S4) et partiellement couverte par la quatrième grille (G4).

6. Mémoire non volatile (100) selon la revendication 5, le deuxième transistor à effet de champ à ailette (220) comprenant en outre :
une troisième zone d'extension de source/drain (E3), couplée à la deuxième région de source (S2) et partiellement couverte par la deuxième grille (G2) ; et
une quatrième zone d'extension de source/drain (E4), couplée à la deuxième région de drain (D2) et partiellement couverte par la deuxième grille (G2) ; et
le troisième transistor à effet de champ à ailette (230) comprenant en outre :
une septième zone d'extension de source/drain (E7), couplée à la troisième région de drain (D3) et partiellement couverte par la troisième grille (G3) ; et
une huitième zone d'extension de source/drain (E8), couplée à la troisième région de source (S3) et partiellement couverte par la troisième grille (G3).

7. Mémoire non volatile (100) selon l'une quelconque des revendications 1 à 6, la deuxième grille (G2) étant couplée à la troisième grille (G3).

8. Mémoire non volatile (100) selon l'une quelconque des revendications 1 à 7, la première région de source (S1) étant couplée à la quatrième région de source (S4).

9. Mémoire non volatile (100) selon l'une quelconque des revendications 1 à 8, la première grille (G1) étant couplée à la quatrième grille (G4).

10. Mémoire non volatile (100) selon l'une quelconque des revendications 1 à 9, la structure à ailettes (140) étant un puits P sur un substrat de silicium et toutes les régions de source (S1, S2, S3 et S4), toutes les régions de drain (D1, D2, D3 et D4) et toutes les régions de source/drain (SA et SB) étant formées par un procédé épitaxial de silicium-phosphore ou de carbure de silicium.

11. Mémoire non volatile (100) selon l'une quelconque des revendications 1 à 10, chacune parmi la première grille (G1), la deuxième grille (G2), la troisième grille (G3) et la quatrième grille (G4) présentant une forme de U pour chevaucher trois côtés latéraux de la structure à ailettes (140).

12. Mémoire non volatile (100) selon l'une quelconque des revendications 1 à 11, la grille de partage (GA) présentant une forme de U pour chevaucher trois côtés latéraux de la structure d'isolation à rupture de diffusion unique (134).

13. Procédé de programmation d'un réseau de mémoire (600) comprenant :
la fourniture d'un réseau de mémoire (600) comprenant une pluralité de mémoires non volatiles (100), chacune étant la mémoire non volatile (100) selon la revendication 1 ;
la fourniture d'une première tension (V1) située dans la plage de 0,6 volt à 1,4 volt à des premières grilles (G1) ou à des quatrièmes grilles (G4) de mémoires non volatiles (100) au niveau d'une rangée sélectionnée (WL1) du réseau de mémoire (600) ;
la fourniture d'une deuxième tension (V2) située dans la plage de 1,2 volt à 2,2 volts à des deuxièmes grilles (G2) et à des troisièmes grilles (G3) de la pluralité de mémoires non volatiles (100) du réseau de mémoire (600) ;
la fourniture d'une troisième tension (V3) située dans la plage de 3,6 volts à 5,5 volts aux grilles de partage (GA) de la pluralité de mémoires non volatiles (100) du réseau de mémoire (600) ; et
la fourniture d'une tension de masse (Vg) à des premières régions de source (S1) de mémoires non volatiles (100) au niveau d'une colonne sélectionnée (BL) du réseau de mémoire (600) ;
la troisième tension (V3) étant supérieure à la première tension (V1) et à la deuxième tension (V2) et la première tension (V1) et la deuxième tension (V2) étant supérieures à la tension de masse (V3).

14. Procédé selon la revendication 13, comprenant en outre :
la fourniture de la première tension (V1) à des premières régions de source (S1) de mémoires non volatiles (100) au niveau de colonnes non sélectionnées (BL1) du réseau de mémoire (600).

15. Procédé selon l'une quelconque des revendications 13 à 14, comprenant en outre :
la fourniture de la tension de masse (Vg) à des premières grilles (G1) et à des quatrièmes grilles (G4) de mémoires non volatiles (100) au niveau de rangées non sélectionnées (WL2) du réseau de mémoire (600).
